# EUROPEAN PATENT APPLICATION

(11) **EP 4 668 582 A1**
(43) Date of publication of application: **24.12.2025**
(21) Application number: 24183105.6
(22) Date of filing: 19.06.2024
(51) Int. Cl.: H03K 17/082, H02M 1/32, H02M 7/5387

(54) **A POWER CONVERSION DEVICE FOR AN ELECTRICAL CAR**

(71) Applicant: Volvo Car Corporation, 405 31 Göteborg (SE)
(72) Inventor: Zhang, Chi, SE-405 31 Göteborg (SE)
(74) Representative: Nederlandsch Octrooibureau

(57) **Abstract**

A power conversion device for an electrical car configured to convert direct current, DC, into alternating current, AC, for powering an electric motor comprising a DC busbar comprising a positive and negative terminal for connecting to a DC power source and configured to distribute said DC power; one or more half-bridges comprising two series-connected power semiconductor switches with a connection joint in between, said half-bridges connected to said DC busbar for converting said DC power into AC power and making available said AC power at said connection joints; an AC busbar connected to said connection joints and comprising an AC terminal; a decoupling circuit per half-bridge comprising a capacitor connected over said respective half-bridge configured to reduce a power loop stray inductance per power loop characterized in that at least one decoupling circuit is further configured as a short circuit detection system for said power conversion device.

## Description

### Technical field

The present disclosure relates to the field of electrical cars, and in particular to a power conversion device configured to convert direct current, DC, originating from a power source into alternating current, AC, for powering an electric motor of an electrical car.

### Background art

Electric cars are propelled by an electric traction motor using energy stored in on-board batteries. These batteries are a source of electric power comprising one or more electrochemical cells with external connections, namely a positive terminal and a negative terminal. When charged a voltage difference between the positive and negative terminals arises. The voltage difference allows to let flow an electric current when an apparatus is connected with the terminals. The electric current is of the direct current, DC, type.

The electric traction motor can be of the type alternating current, AC. Therefore, when the electric car comprises an AC motor, the electric power originating from the batteries needs to be converted. In other words, the DC current needs to be converted into AC current.

It is known that a power inverter may convert DC into AC. An inverter is characterized by its input voltage, output voltage and frequency, and overall power.

When inverting the electric power, a short circuit may occur at the electric AC motor. If so, the short circuit peak current should preferably be reduced, and the inverter should be switched off as quickly as possible to avoid further damages.

### Summary

A power conversion device for an electrical car configured to convert direct current, DC, into alternating current, AC, for powering an electric motor according to the present disclosure comprises a DC busbar comprising a positive and negative terminal for connecting to a DC power source and configured to distribute the DC power, a set of one or more half-bridges each comprising two series-connected power semiconductor switches with a connection joint in between, the one or more half-bridges connected to the DC busbar for converting the DC power into AC power and making available the AC power at the connection joints, an AC busbar connected to the one or more connection joints and comprising an AC terminal, a decoupling circuit per half-bridge comprising a capacitor connected over the respective half-bridge configured to reduce a power loop stray inductance per power loop, characterized in that at least one decoupling circuit is further configured as a short circuit detection system for the power conversion device.

The power conversion device is configured to be integrated in an electrical car. It is further configured to convert or transform DC current originating from a battery pack within the electrical car into AC current for powering an AC electric motor which drives the car.

The power conversion device comprises a DC busbar with a positive and negative terminal for connecting it to the battery pack of the car. The busbar serves as a distribution point for carrying the DC electric power to the power semiconductor switches as will further be discussed. The busbar is typically made of a highly conductive material such as copper or aluminum to minimize resistive losses and ensure efficient power distribution. The terminals are designed to allow a secure and safe attachment to other components, such as the battery pack.

A half-bridge is a circuit configuration used in motor control and power conversion applications. It comprises two power semiconductor switches connected in series with a center tap, the connection joint, which can be connected to the load of the electric motor. It allows controlling the direction and magnitude of the current flowing through the electric motor. The power conversion semiconductor switches comprise preferably one of the group of a metal-oxide-semiconductor field-effect transistor, MOSFET, an insulated-gate bipolar transistor, IGBT, and/or a gate turn-off thyristor, GTO. It should however be understood that other types of power conversion semiconductor switches could be employed and that the type is not a restriction of the present disclosure.

It should be further understood that features of a half-bridge implicitly comprise control signals to control the operation of the half-bridge and switching functions. The operation of the half-bridge is controlled by its gate terminals. Further, by alternating the switching states of the power conversion semiconductor switches the half-bridge can control the voltage polarity and magnitude across the electric motor. The control means could be part of the half-bridge, or alternatively could be external control means configured to be connected to the half-bridge. Accordingly, according to an embodiment, the power conversion device comprises a gate integrated circuit, IC, configured to control the gates of the one or more half-bridges for converting the DC into the AC.

Likewise, as the DC busbar, there is also an AC busbar for carrying the AC power to the electric motor. The cross-sectional area of the AC busbar is designed based on factors such as the magnitude of the current, voltage, and length of the busbar. According to an embodiment, the DC busbar as well as the AC busbar can be laminated. Note however that this is not a restriction of the present disclosure.

The power conversion device further comprises a decoupling circuit per half-bridge. A decoupling circuit is a circuit designed to protect the semiconductors from voltage spikes, and transient overvoltages that could damage the power conversion device. The key features of a decoupling circuit are absorption of voltage spikes, reduction of switching noise, improvement of switching speed, and enhancement of power efficiency. To achieve these functionalities, the decoupling circuit per half-bridge comprises a capacitor connected over said respective half-bridge configured to reduce a power loop stray inductance per power loop. Said capacitor is also denominated as a decouple capacitor.

A power loop stray inductance is an unintended inductance present in the current path of the power loop. It arises from various components and parasitic elements within the loop, such as traces, connectors, vias, and package structures of the components and the power conversion device itself. A power loop is the circuit path that connects the power supply to the electric motor and back to the power supply.

The power conversion device according to the present disclosure is characterized in that at least one decoupling circuit is configured as a short circuit detection system of the power conversion device.

The present disclosure solves the following problems: reduced stray inductance for switching off during short circuit protection, reduced short circuit peak current, reliable switching off process with smaller switching off voltage peak, optimized short circuit detection position selection. Furthermore, the present disclosure is suitable for both printed circuit board, PCB, embedded package, and a package with gate PCD integrated.

Further, the power conversion device comprises one of the group of a silicon carbide, SiC, power module, or a gallium nitride, GaN, power module, but it should be understood that it may comprise other power modules. The power conversion device may further comprise a PCB embedded package.

A conventional desaturation, DESAT, protection feature requires a blanking time to avoid mis-trigger under normal switching. This is because the voltage monitored to detect a fault by the DESAT protection feature share a similar decreasing trend under normal switching and short-circuits incidents.

However, the voltage over the capacitor present in a decoupling circuit shows a different trend. Under a short-circuit incident, a fast voltage dip is observed in contrast to a normal switching event. This means that there is no need to consider a blanking time to avoid mis-trigger during a switching process. This gives the advantage that there is a smaller response time under a shot-circuit incident.

Differently formulated, instead of measuring a drain source voltage over the power conversion device, the disclosed short-circuit protection feature measures the voltage over the decouple capacitor of a decoupling circuit. This results in a reduced short circuit peak current. Furthermore, a more reliable switching off process with smaller switching off voltage peaks is obtained.

In high-power applications several half-bridges will be used in parallel to increase the current capability of the power conversion device. Consequently, multiple decoupling circuits and associated decouple capacitors will be used within the power conversion device. In said case, there is an optimized short-circuit detection position selection. According to an embodiment, when the power conversion device comprises at least two half-bridges, the decoupling circuit configured as the short-circuit detection system is that one having the highest impedance path to the positive and negative terminal.

It has been further observed that in case different half-bridges and thus decoupling circuits are present, that the decoupling capacitor that is the most far away from the terminals shows a higher and faster voltage dip compared to the other ones. When the decoupling circuit associated with said decoupling capacitor is configured as the short-circuit detection system, a short circuit is detected in a more optimized and efficient manner. It just be further understood that the most far away decoupling capacitor should be interpreted in the electrical meaning, thus having the highest impedance path to the positive and negative terminal. Depending on the lay-out of the power conversion device this can likewise be the most far away from a mechanical point of view. Thus, based on the DC power terminal positions, the decoupling capacitor that is the most far away from said terminal positions is selected as the detection point of the short circuit detection system.

Optionally, according to an embodiment, the decoupling circuit configured as the short circuit detection system comprises a high-pass filter connected over its respective capacitor and to one gate of one of its respective power semiconductor switches.

According to a second aspect, a power conversion system configured to convert direct current, DC, into alternating current, AC, for powering an electric motor is disclosed, said system comprising a power conversion device according to the first aspect of the disclosure, and a DC power source connected to the positive and negative terminal of the DC busbar.

According to an embodiment, the power conversion system further comprises said electric motor.

According to a third aspect, an electrical car comprising the power conversion system according to the second aspect is disclosed.

### Brief description of the drawings

A power conversion device according to the disclosure will, by way of non-limiting example, be described in detail with reference to the accompanying drawings. In the drawings:
Fig. 1 shows a conventional desaturation, DESAT, protection system in case of short circuit,
Fig. 2 shows a printed circuit board, PCB, embedded package, and a silicone gel moulded package,
Fig. 3 shows a decoupling circuit configured as a short circuit detection system,
Fig. 4 shows a trend of voltages under normal switching and short circuit incidents of a DESAT protection system respectively a decoupling circuit,
Fig. 5 shows a single die short circuit protection performance comparison between a DESAT protection system and a decoupling circuit,
Fig. 6 shows parallel die inside a package,
Fig. 7 shows an embodiment of an intelligent power module, IPM, with an integrated short circuit protection system,
Fig. 8 shows a trend of voltages over a set of decouple capacitors of a set of corresponding decoupling circuits inside a package under short circuit incidents.

### Detailed Description

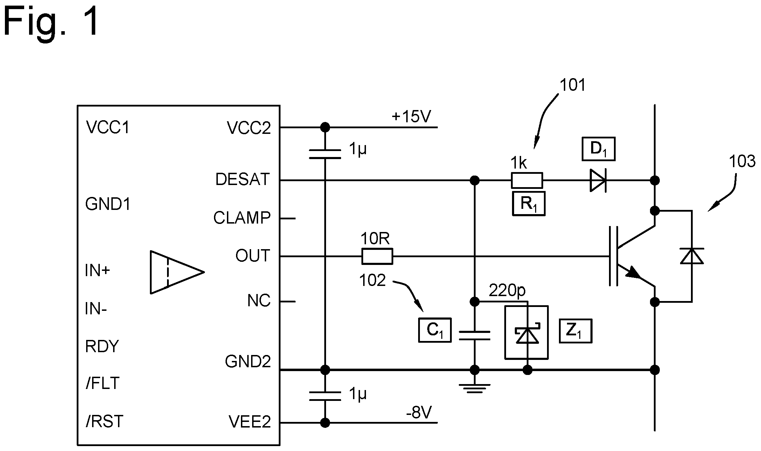

Figure 1 shows a conventional desaturation, DESAT, protection system in case of short circuit. Resistor R₁ 101 and capacitor C₁ form a low pass filter to avoid mis-triggering in case of normal operation. However, this introduces a delay to the short circuit protection process, and this means it is difficult to push the short circuit protection process from 10µs to 3µs while considering the noise impact. A conventional DESAT method has therefore the drawback that reduced R₁ and C₁ value would increase the protection speed. But it will make the circuit more sensitive to noise, and therefore more prone to have mis-triggering. DESAT is based on ON voltage of power semiconductor 103. Furthermore, the protection point is drifted with temperature. High switching off current will take place in case of short circuit. If the stray inductance is not optimized, higher switching off voltage stress will be seen on the power semiconductor 103.

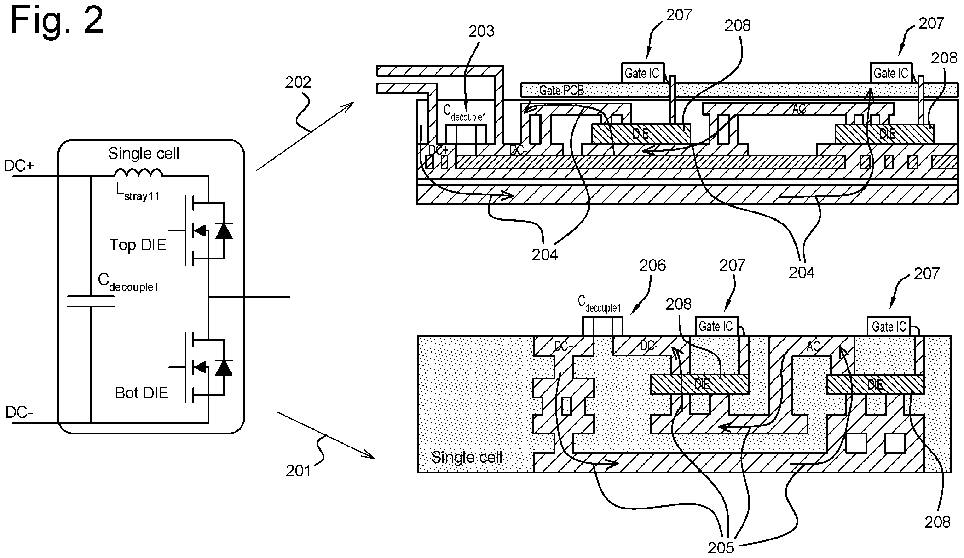

With the present disclosure, a reduced stray inductance for switching off during short circuit protection is obtained. To this end, two packages are considered. Figure 2 shows a decoupling circuit using different packages, namely a printed circuit board, PCB, embedded package 201, and a silicone gel moulded package 202. In both packages 201, 202 a laminated concept for power loop is disclosed. This is illustrated by the arrows 204 and 205 which represent a current power loop. This way an optimized magnetic field cancellation effect is achieved. Further, decoupling capacitor C_{decouple} 203, 206 is integrated in the package 201, 202. This contributes to shrink the power loop 204, 205 for high frequence current further. It also brings down the stray inductance of the power loop 204, 205 not only for normal switching but also for short circuit incidents. Note that there are other alternatives to implement overlap power loop, such as copper clip.

By incorporating the decoupling capacitor 203, 206 inside the package 201, 202, the present disclosure allows to have direct access to die. At the same time, the decoupling capacitor 203, 206 further reduces the power loop 204, 205 stray inductance.

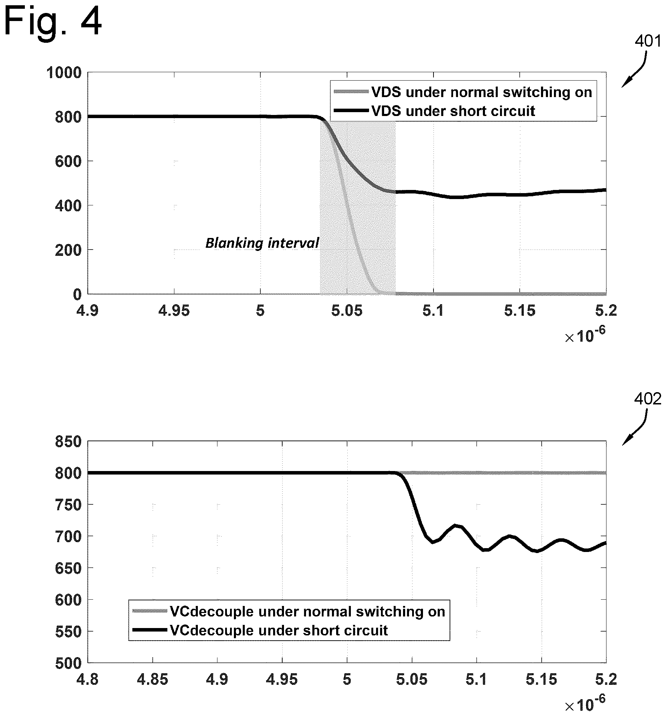

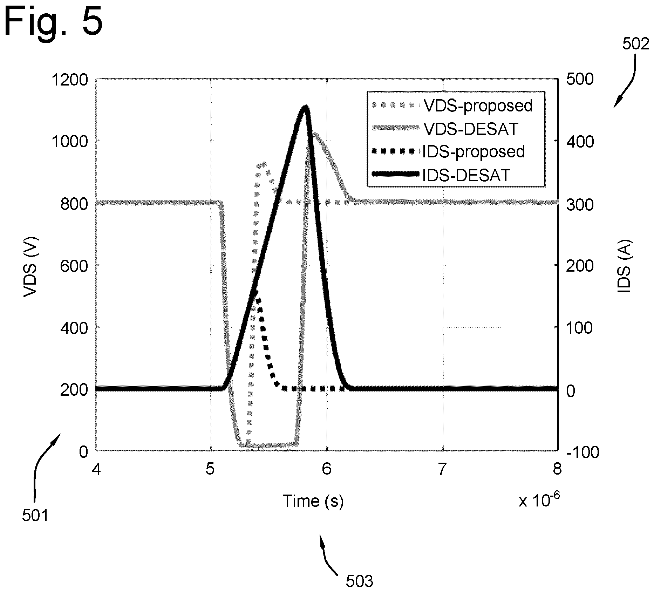

Figure 5 shows a single die short circuit protection performance comparison between a DESAT protection system and a decoupling circuit. On the left side of the graph the voltage of the drain source VDS 501 is presented and on the right side of the graph the current through the drain source IDS 502 is presented, both expressed over a time period 503. As can be observed, there is no blanking time with the present disclosure, which shows a faster protection process with a much smaller short circuit peak current for single power semiconductor DIE. The response time for short circuit voltage VDS is reduced. The short circuit peak current is reduced from 450A to 150A, which also brings a smaller VDS peak during the switching off process, moving from more than 1kV to around 0.9kV. Figure 4 likewise illustrates the difference between a conventional DESAT short circuit protection system 401 and a decoupling circuit 402 according to an embodiment of the present disclosure.

The line indicated as "VDS under normal switching on" in 401 of Figure 4 shows the voltage of the drain source VDS in normal switching on. In that case, the drain source VDS can reach quite a low value below 5 Volts. The line indicated as "VDS under short circuit" in 401 of Figure 4 shows the voltage of the drain source VDS 501 in short circuit. In that case, the voltage of the drain source VDS follows a similar trend as under normal switching on. This similar trend could result in mis-trigger under normal switching on if conventional DESAT is used without blanking time. So, a blanking interval is added to make that conventional DESAT is not disabled during blanking interval. This blanking interval will result in delays and longer protection time. This is not good for wide band gap device.

The line indicated as "VC decouple under normal switching on" in 402 of Figure 4 shows the voltage across the decoupling capacitor in normal switching on. The line indicated as "VC decouple under short circuit" in 402 of Figure 4 shows the voltage across the decoupling capacitor in short circuit. In this case, since the voltage across decoupling capacitor is completely different under normal switching on and short circuit, there is no need to add a blanking interval to avoid mistriggering. This results in a faster short circuit protection.

Simultaneously, as illustrated in Figure 2, the gate driver part, gate IC, 207 is placed extremely close to the semiconductor die 208. This brings a smaller gate stray inductance and means less possibility for gate oscillation, which means that a higher reliability for gate oxide of silicon carbide, SiC, is achieved. Furthermore, since the decoupling capacitor 203, 206 is put directly into the package 201, 202, meaning just next to the die 208, it also leads to a much smaller loop for the short circuit detection with a smaller parasitic inductance.

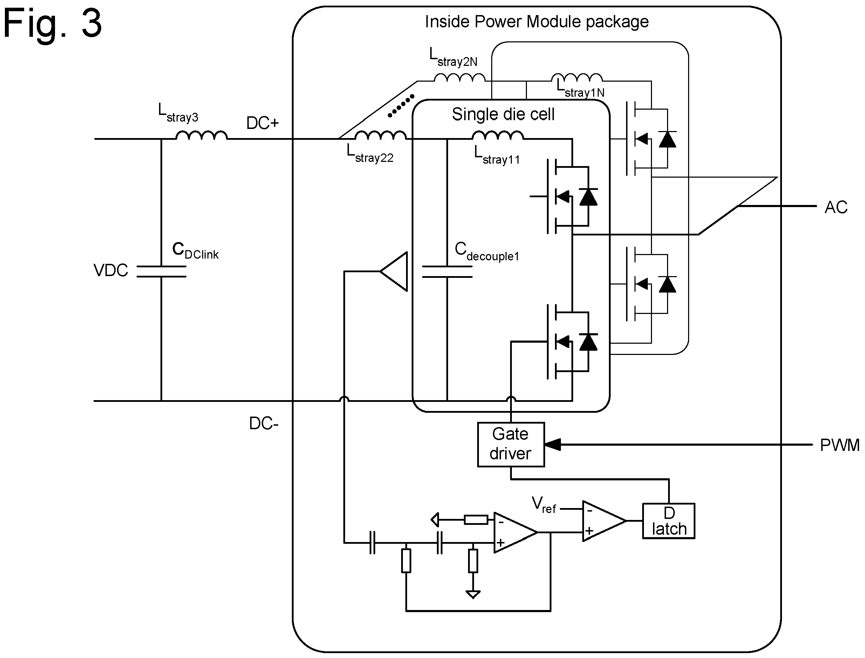

With references to Figures 3, 6 and 7 more details of the present disclosure are showed using a molded package solution.

Firstly, there is an integration of a printed circuit board, PCB, together with direct short circuit protection for die and capacitor integration. In Figure 3, a Half-bridge, H-bridge, is shown, which refers to the four power semiconductor switches having a common AC point, and this illustrated technology likewise applies to other topologies, such as for example three level neutral clamp.

Figure 3 shows the proposed short circuit detection of wide band gap device power module. In high power application, it requires many power semiconductor dies working in parallel. In Figure 3, a number of H-bridges (single die cell) are working in parallel. Lstray11 to Lstray1N shows the parasitic inductance inside the H-bridges. Each H-bridge has a specific decoupling capacitor Cdecouple1 to CdecoupleN (not shown). Lstray22 to Lstray 2N are the corresponding stray inductances between the parallel H-bridges. According to the disclosure, the voltage across the decoupling capacitors Cdecouple1 to CdecoupleN will be measured. Then a high pass filter is used to filter the measured voltage and the output of the high pass filter is sent to a comparator to compare with Vref. The output of the comparator is sent to a D latch to lock the short circuit trigger status and the output of the D latch is sent to the gate driver to trigger the short circuit protection.

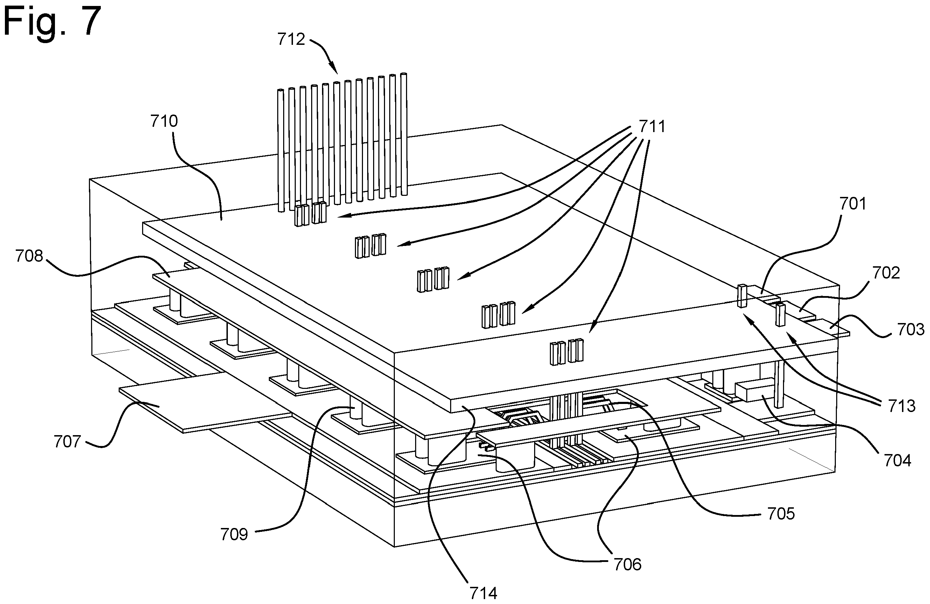

In Figure 7, the following features are disclosed:
- A first negative DC terminal 701,
- A positive DC terminal 702,
- A second negative DC terminal 703,
- A decoupling capacitor 704,
- A bonding wire 705,
- A wide bandgap semiconductor die 706,
- An AC terminal 707,
- A copper busbar 708,
- A spacer 709,
- A gate PCB 710,
- Gate pins 711,
- Singal pins for power module 712,
- PCB 714, and
- Short circuit detection pins 713.

Decoupling capacitors 704 are embedded inside the package to reduce power loop stray inductance and provide a direct detection position for short circuit. The capacitor that is the most far away from the DC terminals 701-703 is selected as the detection point as shown by Figure 7. The DC+ and DC- terminals are placed at the outside of the package in a plane parallel to the top and bottom surface and between these surfaces. The decoupling capacitor704 on the far edge is selected as the detection point of the short circuit.

Soldering pins, also denominated as short circuit detection pins 713, are used to connect the selected decoupling capacitor's voltage to the gate PCB 710 inside package. Gate IC, power supply and short circuit protection are placed on the PCB 714. Further the details of the circuit for short circuit detection are illustrated in Figure 3.

Moreover, the gate of wide-bandgap semiconductor, WBG, DIEs are also connected out using bonding wire as shown in Figure 7 by reference 706. Since the PCB is just on top of DIE, the gate loop is reduced as much as possible. The DIEs can be driven by either parallel operation with one gate pins or independently driven with gate pins 711 for each DIE. With the help of soldering copper pins, the gate signal from inside gate PCB can control the parallel DIEs directly.

The input pins of the Gate PCB, namely signal pins for power module 712, are connected out. Once gate signal and power supply are connected through signal pins for power module 712, the WBG DIEs are controllable.

The interconnection for parallel die is using specifically designed laminated busbar, namely a copper busbar 708. Further, the spacers 709 offer an enhanced magnetic field cancellation effect, which helps to reduce stray inductance further.

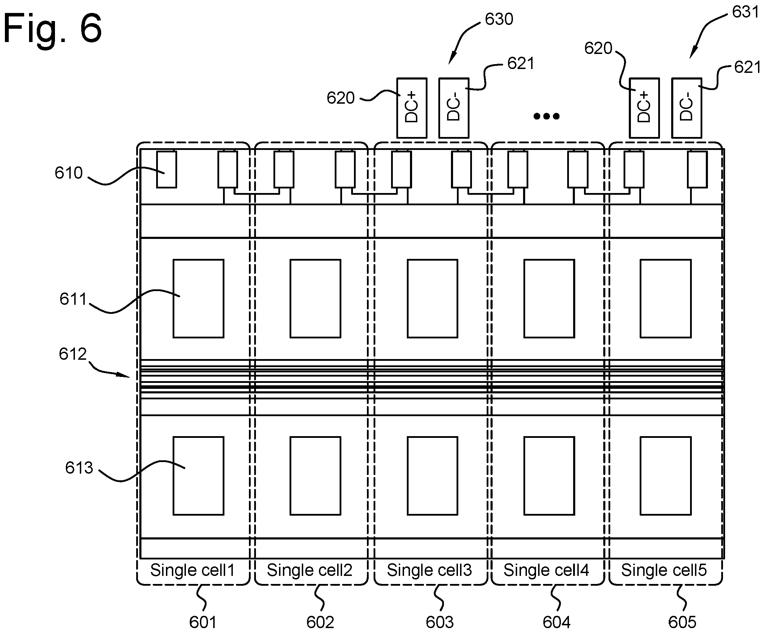

Figure 6 illustrates a top view of a power conversion device according to an embodiment having five half-bridges 601-605. It further illustrates decouple capacitors 610, top dies 611, gates 612, and bottom dies 613. Thus, hereby five dies are considered with ten decuple capacitors 610 that are put into the package between the DC+ terminal 620 and DC- terminal 621.

When considering the DC+ 620 and DC- 621 terminals positions, there are typically two options as shown by Position A and Position B in Fig. 7.

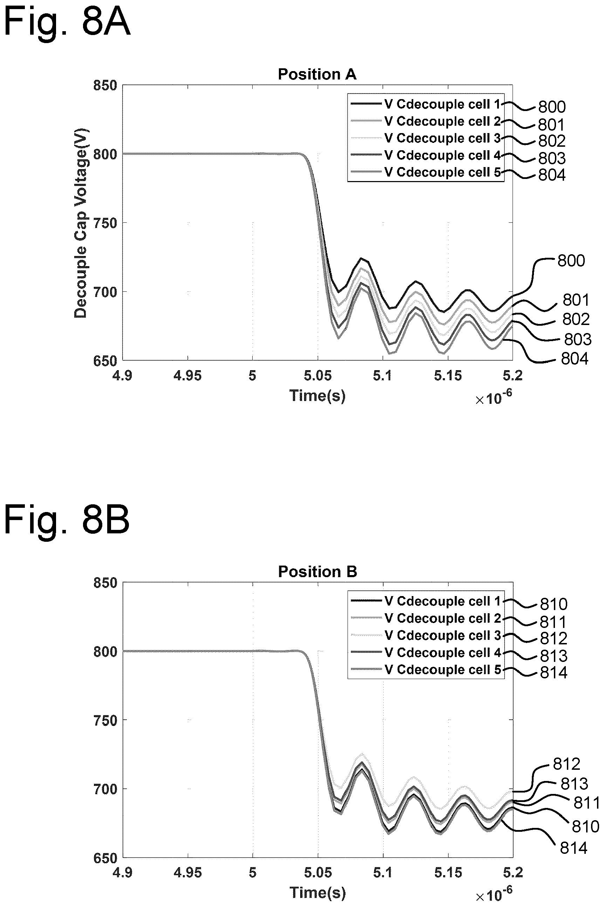

Fig. 8 shows voltage across decouple capacitor of different cells under short circuit when DC+ and DC- power terminals in Position A 631 and Position B 630. It can be seen that the decoupling capacitor that is the most far away from the terminals always shows a higher and faster voltage dip, which is easier to be detected. This is illustrated in Figure 8 illustrating the voltages 800-804 (Figure 8A) and 810-814 (Figure 8B) over the decoupling capacitors 610 respectively for these two distinct positions 630 and 631. So based on DC+ and DC- power terminal positions, the decoupling capacitor that is the most far away is selected to be as the detection point.

## Claims

1. A power conversion device for an electrical car configured to convert direct current, DC, into alternating current, AC, for powering an electric motor, said device comprising:
- a DC busbar comprising a positive and negative terminal for connecting to a DC power source and configured to distribute said DC power;
- a set of one or more half-bridges each comprising two series-connected power semiconductor switches with a connection joint in between, said one or more half-bridges connected to said DC busbar for converting said DC power into AC power and making available said AC power at said connection joints;
- an AC busbar connected to said one or more connection joints and comprising an AC terminal;
- a decoupling circuit per half-bridge comprising a capacitor connected over said respective half-bridge configured to reduce a power loop stray inductance per power loop;
**characterized in that** at least one decoupling circuit is further configured as a short circuit detection system for said power conversion device.

2. The power conversion device according to claim 1, wherein the short circuit detection system is configured to detect a short circuit based on a voltage over the capacitor of the decoupling circuit configured as the short circuit detection system.

3. The power conversion device according to any of the preceding claims, wherein the decoupling circuit configured as the short circuit detection system comprises a high-pass filter connected over its respective capacitor and to one gate of one of its respective power semiconductor switches.

4. The power conversion device according to any of the preceding claims, wherein when the power conversion device comprises at least two half-bridges, the decoupling circuit configured as the short circuit detection system having the highest impedance path to the positive and negative terminal.

5. The power conversion device according to any of the preceding claims, wherein the power semiconductor switches comprise one of the group of a metal-oxide-semiconductor field-effect transistor, MOSFET, an insulated-gate bipolar transistor, IGBT, and/or a gate turn-off thyristor, GTO.

6. The power conversion device according to any of the preceding claims, further comprising a gate integrated circuit, IC, configured to control the gates of the one or more half-bridges for converting the DC into the AC.

7. The power conversion device according to any of the preceding claims, wherein the DC busbar and/or the AC busbar is laminated.

8. The power conversion device according to any of the preceding claims, wherein the power conversion device comprises one of the group of a silicon carbide, SiC, power module, or a gallium nitride, GaN, power module.

9. The power conversion device according to any of the preceding claims comprising a printed circuit board, PCB, embedded package.

10. A power conversion system configured to convert direct current, DC, into alternating current, AC, for powering an electric motor, said system comprising a power conversion device according to any of the preceding claims, and a DC power source connected to the positive and negative terminal of the DC busbar.

11. The power conversion system according to claim 10 further comprising said electric motor.

12. An electrical car comprising the power conversion system according to any of the claims 10 to 11.
